(19) Europäisches Patentamt
European Patent Office
Office européen des brevets

(11) **EP 0 662 615 B1**

(12) **EUROPÄISCHE PATENTSCHRIFT**

(45) Veröffentlichungstag und Bekanntmachung des Hinweises auf die Patenterteilung:
**01.10.1997 Patentblatt 1997/40**

(51) Int Cl.[6]: **G01R 31/02**

(21) Anmeldenummer: **94120506.4**

(22) Anmeldetag: **23.12.1994**

(54) **Verfahren zur Kurzschlusserkennung in Bahnnetzen**

Method for detecting short circuits in railway networks

Méthode pour détecter des court-circuits en réseaux de chemin de fer

(84) Benannte Vertragsstaaten:
**AT CH FR GB IT LI NL SE**

(30) Priorität: **05.01.1994 DE 4400234**

(43) Veröffentlichungstag der Anmeldung:
**12.07.1995 Patentblatt 1995/28**

(73) Patentinhaber: **elbas ELektrische BAhnSysteme Ingenieur-Gesellschaft mbH**
**01097 Dresden (DE)**

(72) Erfinder: **Lösel, Dr. Thomas**
**D-01069 Dresden (DE)**

(74) Vertreter: **Kailuweit, Frank, Dr. Dipl.-Ing. et al**
**Kailuweit & Uhlemann,**
**Patentanwälte,**
**Postschliessfach 27 01 39**
**01171 Dresden (DE)**

(56) Entgegenhaltungen:
**DE-A- 1 965 425        US-A- 4 767 996**

## Beschreibung

Die Erfindung betrifft ein Verfahren zur Kurzschlußerkennung in Bahnnetzen beim Einsatz der Netzbremse eines Triebfahrzeuges (E-Lok, S- oder U-Bahntriebzug, Triebwagen der Straßenbahn, Obus) sowie eine Schaltungsanordnung zur Durchführung des Verfahrens.

Eine bekannte Voraussetzung dafür, daß bei Triebfahrzeugen mit Netzbremse eine Rückspeisung elektrischer Energie in das Bahnstromnetz erfolgt, ist, daß die Fahrleitungsspannung des Triebfahrzeuges höher eingestellt ist als die des Bahnstromunterwerkes. Befindet sich das Triebfahrzeug in geringem Abstand zu einem Unterwerk und tritt in dieser Situation in größerer Entfernung vom Triebfahrzeug ein Kurzschluß auf, so würde das Triebfahrzeug bei Betätigung der Netzbremse seine elektrische Bremsenergie an den Ort des Kurzschlusses übertragen, der wie ein elektrischer Verbraucher wirkt. Es wurde überraschenderweise festgestellt, daß das benachbarte Bahnstromwerk unter den vorstehend genannten Voraussetzungen den Kurzschluß im Netz nicht oder nicht mit ausreichender Sicherheit erkennen kann und die im Bahnstromwerk vorhandenen Schutzmaßnahmenn keine Unterbrechung der Stromzufuhr veranlassen würden.

Zur Vermeidung gefährlicher Zustände in einer Energieversorgungsanlage wird gefordert, daß bei Kurzschlüssen unter allen Umständen eine Abschaltung des betroffenen Speiseabschnittes erfolgt. Deshalb verfügen Unterwerke über Schutzeinrichtungen, die einen Kurzschluß erkennen sollen. Während des Einsatzes der Netzbremse speisen bremsende Fahrzeuge ihre kinetische Energie in das Fahrleitungsnetz zurück. Dadurch übernehmen diese Fahrzeuge zeitweise die Funktion der Unterwerke. Wenn die Spannung am Stromabnehmer und am Filterkondensator des Fahrzeuges unter einen bestimmten Schwellwert sinkt, wird die Netzbremse durch entsprechende Einwirkung der Fahrzeugsteuerung wirkungslos gemacht (Unterspannungsschutz laut DIN VDE 0115 Teil 1). Somit ist bei fahrzeugnahen Kurzschlüssen ein Kurzschlußschutz gegeben. Eine weitere Ursache für die Abschaltung der Netzbremse bei Unterspannung ist in der Tatsache zu sehen, daß bei einer zu geringen Spannung keine Energie mehr in das Netz gespeist werden kann. Bei Fahrzeugen mit Gleichstromsteller kommt hinzu, daß der Steller im Bremsbetrieb nicht mehr sicher arbeitet, wenn die Eingangsspannung unter einen bestimmten Wert sinkt, weil die Eingangsspannung stets größer als die Spannung am Stellerausgang sein muß.

Zum Stande der Technik bezüglich der Erkennung von Kurzschlüssen ist folglich sowohl die Unterwerksschutztechnik als auch die Abschaltung der elektrischen Netzbremse des Fahrzeuges bei Unterspannung zu rechnen. Die derzeitig angewandten Schutzeinrichtungen im Unterwerk beschreibt der Aufsatz "Calculation of remote short circuit fault currents for DC railways" von J.C. Brown u. a. in: IEEE Proceedings-B, Vol. 179, No. 4, July 1992, S. 289 bis 294.

Bei Messungen zeigte es sich jedoch, daß unter bestimmten Bedingungen einerseits die Schutzeinrichtungen im Unterwerk den Kurzschluß nicht erkennen können, andererseits die Spannung am Stromabnehmer bzw. Filterkondensator nicht unter den Schwellwert sinkt, der zur Abschaltung der Netzbremse führt. Deshalb ist der Schutz vor Kurzschlüssen nicht unter allen Bedingungen sicher gewährleistet, sondern es gibt einen ungeschützten Bereich. Untersuchungen zeigten, daß dieser Bereich auch bei veränderten Einstellungen der Schutztechnik nach dem Stande der Technik nicht vermieden werden kann. Wie Messungen zeigten, kann in extremen Fällen das bremsende Fahrzeug den Kurzschluß allein speisen, und die Spannung am Filterkondensator dennoch größer sein als die Unterwerksleerlaufspannung.

Dies bedeutet, daß die Schutzeinrichtungen im Unterwerk aufgrund der elektrischen Verhältnisse im Netz den Kurzschluß nicht erkennen, weil im betroffenen Unterwerksabgang kein Strom fließt. Folglich bietet ein von einer Stromanstiegsgeschwindigkeit abhängiger Überstromauslöser mit Zeitverzögerung, wie er in der Patentanmeldung DE 1 965 425 vorgeschlagen wird, keinen sicheren Kurzschlußschutz. Andererseits kann wegen der hohen Spannung am Fahrzeug selbiges den Kurzschluß mit den Mitteln des Standes der Technik nicht erkennen, weil sich die Spannung am Fahrzeug nicht von der im fehlerfreien Betrieb unterscheidet. US-A-4 767 996, welches den nächstliegender Stand der Technik bildet, offenbart ein Verfahren mit den Merkmalen der Präambel von Anspruch 1 sowie eine entsprechende Anordnung mit einem Strom-Spannungs-Wandler, einem ADC und einem Controller.

Der Erfindung liegt die Aufgabe zugrunde, unter allen Bedingungen eine sichere Erkennung eines Kurzschlusses im Leitungsnetz zu ermöglichen.

Diese Aufgabe wird verfahrensgemäß durch die kennzeichnenden Merkmale des Hauptanspruches gelöst. Dazu wird in Intervallen die zeitliche Änderung der Energieaufnahmefähigkeit des Netzes anhand meßbarer Größen am oder im Triebfahrzeug ermittelt. Wird ein zulässiger Schwellwert für die zeitliche Änderung der Energieaufnahmefähigkeit des Netzes überschritten, so wird der Kurzschluß im Triebfahrzeug registriert, die Netzbremse abgeschaltet und das Triebfahrzeug mit anderen Bremssystemen, z.B. mechanisch, abgebremst. Zugleich wird durch die Unterbrechung der Energieeinspeisung in das Netz durch das bislang bremsende Triebfahrzeug die Spannungsüberhöhung im Netz wieder aufgehoben. Damit kann der fortwährende Kurzschluß im Unterwerk sicher erkannt werden und eine Stromabschaltung durch bekannte Schutzeinrichtungen erfolgen.

Im Gegensatz zur Patentanmeldung JP 1 264 501 A, die eine Lösung zur Erkennung der Abtrennung des Netzes (d.h. die schlagartig abnehmende Aufnahmefähigkeit des Netzes mit gefährlichen Folgen für das Fahrzeug) zum Inhalt hat, wird durch die erfindungsgemäße Lösung die aus dem Kurzschluß resultierende scheinbare Zunahme der Energieaufnahmefähigkeit des Netzes registriert.

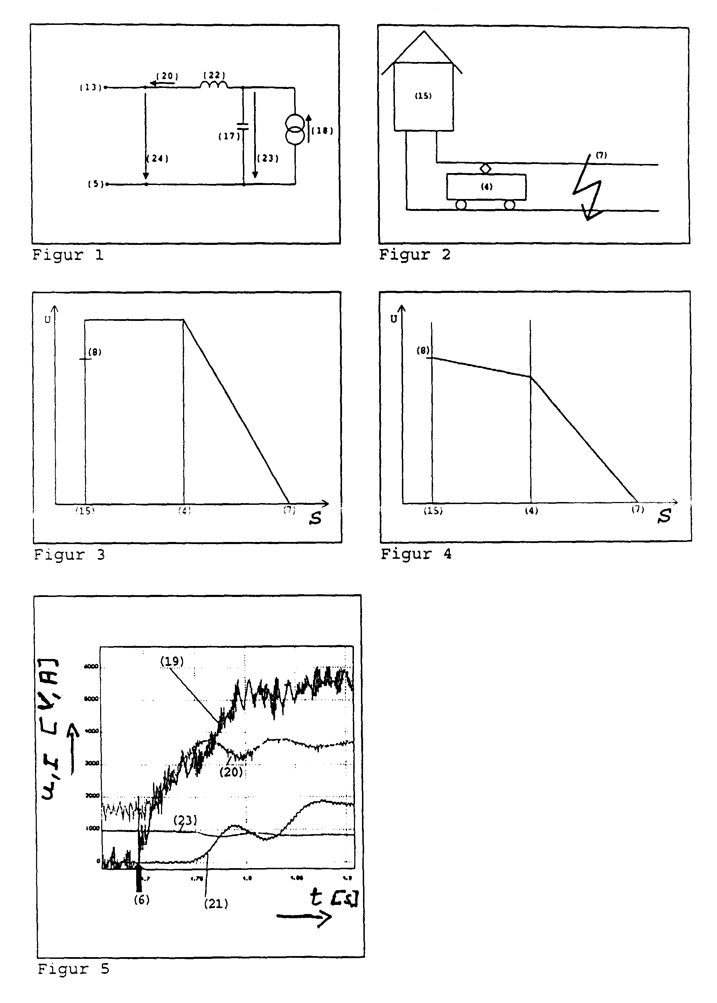

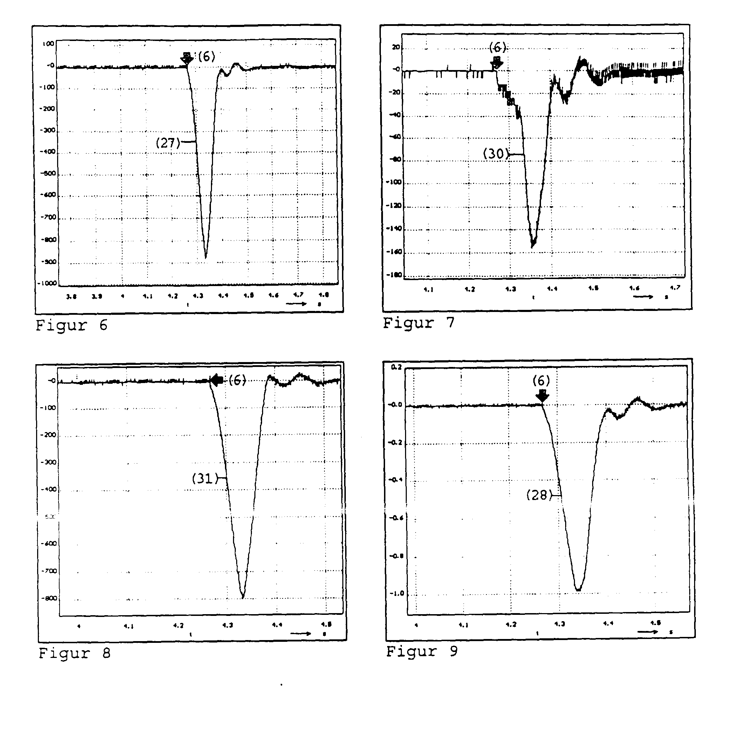

Die sichere Erkennung des Kurzschlusses am oder im Triebfahrzeug wird realisiert durch die intervallartige Bestimmung der zeitlichen Änderung der Energieaufnahmefähigkeit des Netzes durch Bestimmung der ersten Ableitung des vom Triebfahrzeug in das Netz rückgespeisten Stromes $i_{NETZ}$ nach der Zeit oder durch die Bildung des Differenzenquotienten $\Delta i/t_V$ (27). Überraschend wurde festgestellt, daß der Funktionsverlauf $\Delta i/t_V$ (27) zum Zeitpunkt des Kurzschlußeintrittes (6) einen signifikanten Sprung (Fig. 6) aufweist, der eine sichere Erkennung des Kurzschlusses auch bei ungünstigen Bedingungen (Triebfahrzeug (4) befindet sich in der Nähe eines Unterwerkes (15), Ort des Kurzschlusses liegt in größerer Entfernung vom Triebfahrzeug (4); vgl. Fig. 2). ermöglicht.

Im Gegensatz dazu würde mit bekannten Mitteln der Kurzschlußeintritt (6) im Unterwerk (15) erst nach einem größeren Zeitintervall registriert. Figur 5 zeigt ein Meßergebnis. Der Unterwerksabgangsstrom (21) erreicht nicht den zum Ansprechen der Kurzschlußeinrichtung im Unterwerk notwendigen Wert. Der dI/dt-Schutz würde bei der in Fig. 5 aufgezeichneten Messung ebenfalls nicht auslösen. Der Kurzschluß wird erst dann abgeschaltet, wenn die Netzbremse nicht mehr arbeitet. Der Strom an der Kurzschlußstelle (7) setzt sich aus einem Anteil vom Netzstrom des Fahrzeuges iNETZ (20) und einem Anteil vom Unterwerksabgangsstrom (21) zusammen. Auch die Filterkondensatorspannung (23) am Fahrzeug erreicht nicht den Wert, der zur Abschaltung des Triebfahrzeuges führen würde.

In alternativer Weise können auch andere Meßgrößen am oder im Triebfahrzeug für die sichere Erkennung eines Kurzschlusses durch die intervallartige Bestimmung der zeitlichen Änderung der Energieaufnahmefähigkeit des Netzes genutzt werden. So kann vorteilhaft durch die fortlaufende Bestimmung der ersten Ableitung der am Stromabnehmer (13) oder am Filterkondensator (17) des Triebfahrzeuges anliegenden Spannung $u_S$ (24) bzw. $u_F$ (23) nach der Zeit oder durch die Bildung des Differenzenquotienten $\Delta u_S/t_V$ bzw. $\Delta u_F/t_V$ der Kurzschlußeintritt (6) im Netz sicher registriert werden. Analog kann durch mathematische Verknüpfung der am oder im Triebfahrzeug anliegenden Meßgrößen $i_{NETZ}$ und $u_F$ bzw. $u_S$ und die fortlaufende Bestimmung der ersten Ableitung dieser Rechengrößen nach der Zeit oder durch die Bildung der Differenzenquotienten der Eintritt eines Kurzschlusses im Netz bestimmt werden. Die Erfindung bietet dem Betreiber von Bahnnetzen bzw. von elektrischen Bahnen die Möglichkeit, mit geringstem technischen und finanziellen Aufwand einen verbesserten Schutz gegenüber Kurzschlüssen in Bahnnetzen zu realisieren. Dadurch kann eine potentielle Gefährdung der menschlichen Sicherheit beim Aufenthalt unter Fahrleitungen oder im Gleisbereich, z.B. in innerstädtischen Verkehrszonen verhindert werden. Zugleich kann der Rückspeisewirkungsgrad beim Einsatz der Netzbremse verbessert werden.

Vorteilhaft für den Triebfahrzeughersteller ist, daß zur Realisierung des Verfahrens diejenigen physikalischen Größen benutzt werden, die für die Fahrzeugsteuerung ohnehin gemessen werden. Dadurch brauchen keine zusätzlichen Meßwandler o. ä. eingesetzt zu werden. Die vorgeschlagene Lösung ist daher vorteilhaft zur Nachrüstung vorhandener Triebfahrzeuge geeignet.

Ausführungsbeispiele der Erfindung sind in Zeichnungen dargestellt und nachfolgend näher beschrieben:

Es zeigen:

Figur 1: Das bekannte Grundprinzip eines Stromrichtertriebfahrzeuges mit LC-Eingangsfilter,

Figur 2: eine mögliche Konstellation von Unterwerk (15), bremsendem Fahrzeug (4) und Kurzschlußstelle (7), bei der bekannte Schutzeinrichtungen den Kurzschluß nicht erkennen würden

Figur 3: einen ersten möglichen Verlauf der Fahrleitungsspannung entlang der Strecke gemäß Figur 2, wobei der Kurzschluß im Unterwerk nicht registriert werden kann,

Figur 4: einen zweiten möglichen Verlauf der Fahrleitungsspannung entlang der Strecke gemäß Figur 2, wobei die Sicherheit der Kurzschlußerkennung im Unterwerk nicht gegeben ist,

Figur 5: das Ergebnis einer Messung für den in Figur 4 dargestellten Fall, wobei das Unterwerk den Kurzschluß mit Sicherheit nicht erkennen kann,

Figur 6: den zeitlichen Verlauf der ersten Ableitung des Netzstromes $i_{NETZ}$ im Normal- und Kurzschlußfall,

Figur 7: den zeitlichen Verlauf der ersten Ableitung der Filterkondensatorspannung $u_F$ im Normal- und Kurzschlußfall,

Figur 8: den zeitlichen Verlauf der ersten Ableitung des Produktes aus Netzstrom $i_{NETZ}$ und Filterkondensatorspannung $u_F$ im Normal- und Kurzschlußfall,

Figur 9: den zeitlichen Verlauf der genäherten ersten Ableitung des Quotienten aus Netzstrom $i_{NETZ}$ und Filterkondensatorspannung $u_F$ im Normal- und Kurzschlußfall,

Figur 10: eine Schaltungsanordnung in einem Triebfahrzeug zur Duchführung des erfindungsgemäßen Verfahrens

Figur 11: die zeitlichen Verläufe der Bestimmungsgrößen gemäß Ausführungsbeispiel 1, wobei der Differenzenquotient des Netzstromes $i_{NETZ}$ (27) zur Ermittlung des Kurzschlusses genutzt und eine Fehlauslösung erkannt wird,

Figur 12: die zeitlichen Verläufe der Bestimmungsgrößen gemäß Ausführungsbeispiel 1 nach Figur 11, wobei erkannt wird, daß keine Fehlauslösung vorliegt,

Figur 13: die zeitlichen Verläufe der Bestimmungsgrößen gemäß Ausführungsbeispiel 2

Moderne Triebfahrzeuge weisen in der Regel neben elektrischen und mechanischen Bremssystemen zusätzliche Netzbremsen auf, um die kinetische Energie des Fahrzeuges bzw. des gesamten Zuges beim Bremsvorgang an das Bahnnetz zurückzuführen.
Die Netzbremse wird durch leistungselektronische Schaltungen realisiert. Wegen der hohen Induktivität der Fahrleitung und der Stromschiene und zum Dämpfen von Netzoberschwingungen haben Stromrichterfahrzeuge ein aus einer Induktivität $L_{NETZ}$ (22) und einem Filterkondensator $C_F$ (17) bestehendes LC-Filter am Eingang (Figur 1). Der Steller des Fahrzeuges wirkt für das Filter während der Netzbremsung als pulsierende Stromquelle i (18). Der Strom $i_{NETZ}$ (20) muß so geregelt werden, daß das Fahrzeug seine gesamte Bremsenergie in das Netz zurückspeist, sofern genügend Abnehmer vorhanden sind, anderenfalls nur den der momentanen Aufnahmefähigkeit des Netzes entsprechenden Teil. Dazu muß das bremsende Fahrzeug die Spannung (23) am Filterkondensator (17) über die Spannung des Unterwerkes erhöhen.
Figur 2 zeigt eine mögliche Konstellation von Unterwerk (15), Fahrzeug (4) und Kurzschlußstelle (7).
Figur 3 zeigt den zugehörigen Verlauf der Fahrleitungsspannung entlang der Strecke. Das Fahrzeug hebt die Spannung über den Wert der Leerlaufspannung (8) des Unterwerkes (15) an und verhindert damit die Kurzschlußerkennung im Unterwerk. Die Spannung am Filterkondensator beträgt nach dem Abklingen der dynamischen Vorgänge:

$$u_F = i_{FZ} * R_K \qquad (1)$$

In den Gleichungen (1) und (2) bedeuten:

$u_F$ Spannung am Filterkondensator

$i_{FZ}$ Vom Fahrzeugsteller rückgespeister Strom

$i_{UW}$ Strom am Unterwerksabgang

$R_K$ Widerstand der Kurzschlußbahn zwischen Fahrzeug und Kurzschlußort

Figur 4 zeigt einen anderen möglichen Fall. Er ist dadurch charakterisiert, daß die Spannung am Filterkondensator so hoch ist, daß sie zwar kleiner als die Unterwerksleerlaufspannung (8) ist, aber immer noch größer als ein kritischer Wert, bei dem die Netzbremse abgeschaltet werden würde. In diesem Fall gilt für die sich stationär einstellende Spannung am Filterkondensator:

$$u_F = (i_{FZ} + i_{UW}) * R_K \qquad (2)$$

Wenn die Spannung am Filterkondensator $u_F$ kleiner ist als die Unterwerksleerlaufspannung, teilt sich der Kurzschlußstrom in einen Anteil $i_{UW}$ vom Unterwerk und einen Anteil $i_{FZ}$ vom Fahrzeug auf. Der Unterwerksstrom sowie dessen Anstieg sind wesentlich geringer als es ohne den Einsatz der Netzbremse der Fall wäre.
Bei Messungen wurde nachgewiesen, daß die vorgesehenen Schutzeinrichtungen gegen Kurzschluß nach dem Stand der Technik in diesem Fall den Kurzschlußstrom nicht sofort abschalten.
Figur 5 zeigt das Ergebnis einer Messung, bei der das Unterwerk den Kurzschluß nicht abschalten kann. Sowohl der stationäre Wert des Unterwerksstromes (21) als auch sein Anstieg (dl/dt-Schutz) führen nicht zur Abschaltung im Unterwerk. Die Spannung am Filterkondensator (23) liegt über dem zur Abschaltung der Netzbremse führenden Wert.
Das Fahrzeug arbeitet deshalb trotz des Kurzschlusses als Stromquelle und reagiert, als wäre die Aufnahmefähigkeit des Netzes vergrößert. Es fließt so lange ein Kurzschlußstrom (19) an der Kurzschlußstelle, bis die Netzbremse als Folge der verringerten Fahrgeschwindigkeit unwirksam ist. Dadurch kann es zu thermischen Zerstörungen kommen. Unter Umständen entstehen hohe Gleis-Erde-Spannungen (bis 200 V gemessen), die zu einer Gefahr für Leben und Gesundheit von Menschen und Tieren werden können. Deshalb sind Schutzeinrichtungen erforderlich, die diese Gefährdungen abwenden.
Das erfindungsgemäße Verfahren zur Kurzschlußerkennung in Bahnnetzen gewährleistet einen Schutz gegen die genannten Gefahren mit geringem Aufwand. Alternative Möglichkeiten zum Schutz vor den Folgen von unerkannten Kurzschlüssen weisen folgende Nachteile auf:

So kann der ohmsche Widerstand der Fahrleitung und der Stromschiene durch Einsatz von Verstärkungsleitungen oder Verwendung besserer Leitermaterialien reduziert werden. Ebenso könnte der mittlere Abstand benachbarter Unterwerke verringert werden. Diese Maßnahmen sind jedoch material-, zeit- und kostenintensiv.

Ebenso kann durch eine Verringerung der rückgespeisten Netzbremsenergie eine Gefährdung im Kurzschlußfall vermieden werden. Das bedeutet jedoch eine Verschlechterung des Rückspeisewirkungsgrades der Netzbremse und damit höhere Energiekosten für den Betreiber, insbesondere im städtischen Nahverkehr (Straßenbahn, S-Bahn, U-Bahn), wo aufgrund der Haltestellenabstände oder durch verkehrsbedingte Situationen die Triebfahrzeuge und Züge häufig abgebremst werden müssen.

Die Energieaufnahmefähigkeit eines Bahnnetzes ist zeitlich veränderlich, richtet sich nach dem Leistungsbedarf der Verbraucher und kann sich nicht sprungartig ändern. Deshalb kann sich auch der von der Netzbremse eingespeiste Strom nicht sprungartig ändern, sondern nur im Rahmen der Dynamik der Verbraucher.

Genau zum Zeitpunkt des Kurzschlußeintrittes wird der Verlauf der Fahrleitungsspannung entlang der Strecke wesentlich verändert. Diese Veränderung geschieht deutlich schneller als eine Veränderung infolge einer Änderung des Stromes der Verbraucher im Netz. Als Folge davon kommt es zu einer Entladung der Filterkapazität im bremsenden Triebfahrzeug. Die elektrische Ladung der Filterkapazität muß somit an die veränderten elektrischen Verhältnisse angepaßt werden.

Die Erfindung beruht auf dem Gedanken, diese relativ schnell stattfindende Veränderung von Netzstrom und Filterkondensatorspannung zur Erkennung einer sich schnell verändernden Energieaufnahmefähigkeit des speisenden Netzes und damit eines Kurzschlusses zu nutzen.

Eine mathematische Untersuchung mit Hilfe eines Simulationsprogrammes und Messungen zeigten, daß die ersten Ableitungen folgender physikalischer und berechneter Größen im Kurzschlußfall größer sind als im Betriebsfall:

-   des in das Netz gelieferten Stromes $i_{NETZ}$
-   der Spannung am Filterkondensator $u_F$
-   des Produktes p der genannten Größen

$$p = i_{NETZ} * u_F \qquad (3)$$

-   des Quotienten q der genannten Größen

$$q = \frac{i_{NETZ}}{u_F} \qquad (4)$$

Die Figuren 6 bis 9 zeigen, daß alle vier Größen im Kurzschlußfall so groß sind, daß das Überschreiten eines festzulegenden Schwellwertes als sicheres Zeichen für einen Kurzschluß genutzt werden kann.
Die Kurven wurden aus den gemessenen Werten nach den Formeln

$$\frac{di}{dt} \sim i(t) - i(t - t_v) \qquad (5)$$

$$\frac{du}{dt} \sim u(t) - u(t - t_v) \qquad (6)$$

$$\frac{dp}{dt} \sim ((i(t) * u(t)) - (i(t - t_v) * u(t - t_v)) \qquad (7)$$

$$\frac{dq}{dt} \sim \frac{i(t)}{u(t)} - \frac{i(t - t_v)}{u(t - t_v)} \qquad (8)$$

berechnet, wobei die erste Ableitung durch die Differenz zwischen zu einem aktuellem Zeitpunkt t gemessenen und einem um die Zeit $t_v$ älteren Wert bestimmt wurde. Zu einer schnellen Veränderung der elektrischen Verhältnisse in einem Speisebereich eines Unterwerkes kann es auch dann kommen, wenn ein Fahrzeug mit Maximalleistung aus einem anderen Speisebereich in einen Speisebereich einfährt, in welchem bereits ein Fahrzeug bremst. In einem solchen Fall ist ein Abschalten der Netzbremse nicht erwünscht, sondern das bremsende Fahrzeug soll den Energiebedarf des fahrenden Fahrzeuges so gut es möglich ist abdecken.
Zur Erkennung dieser Situation ist das Verfahren zur Bestimmung der Energieaufnahmefähigkeit gemäß Anspruch 8 fortgebildet.

Eine sprungartige Änderung des Energiezustandes des Netzfilters im Triebfahrzeug könnte als Kurzschluß registriert werden, ohne daß ein solcher vorliegt. Unter den eingangs beschriebenen Bedingungen würde das Unterwerk auch in diesem Fall keine Netzabschaltung vornehmen.
Somit unterscheiden sich die erwünschte und die unerwünschte Abschaltung der Netzbremse dadurch, ob nach Ablauf der Ansprechzeit der Unterwerksschutzeinrichtungen die Unterwerksspannung noch am Fahrzeug anliegt oder nicht. Durch die Auswertung dieser Spannung können unerwünschte Abschaltungen der Netzbremse auf die Dauer der Ansprechzeit der Unterwerksschutzeinrichtungen (ca. 150 ms) begrenzt werden.

Anhand von zwei Ausführungsbeispielen soll die technische Realisierung erläutert werden.

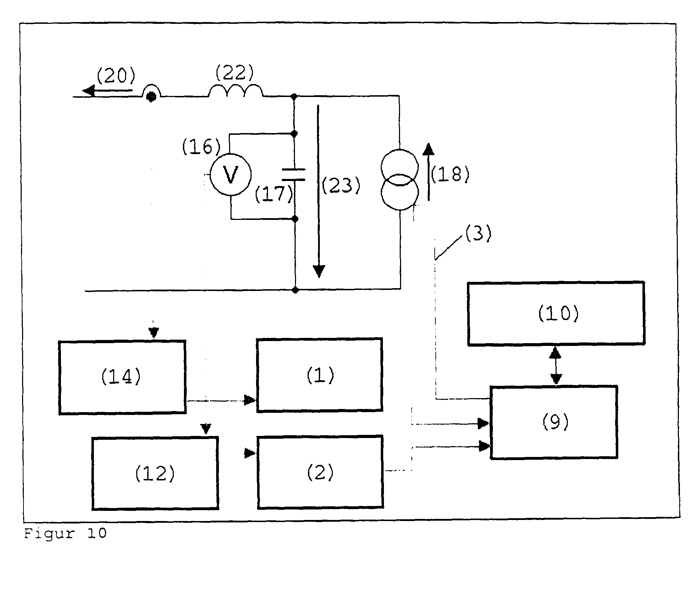

Figur 10 zeigt die technische Lösung für beide Ausführungsbeispiele.

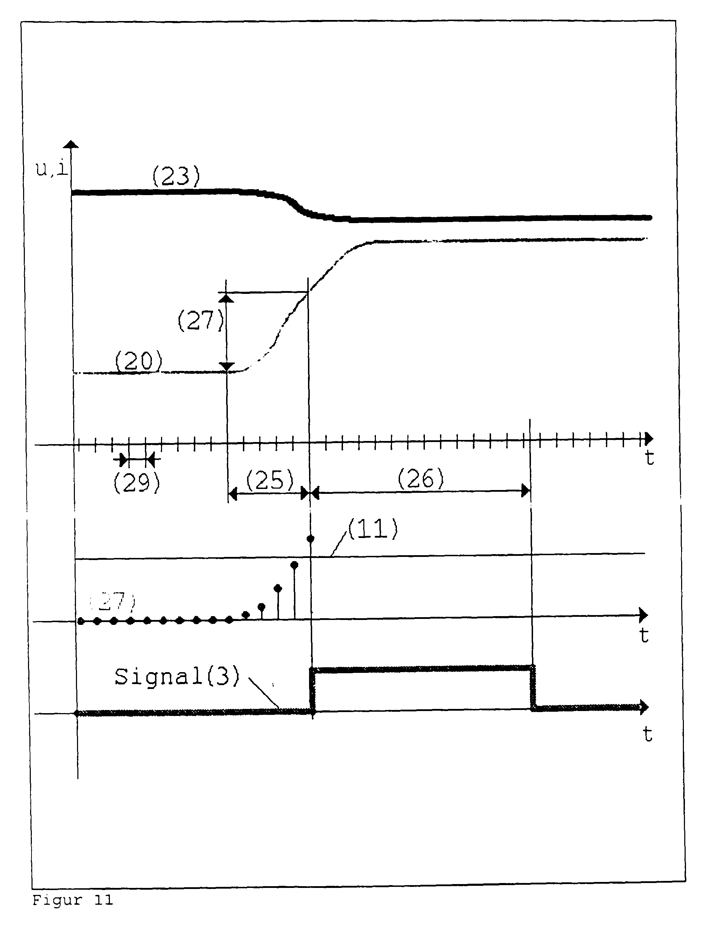

In Figur 11 sind die zeitlichen Verläufe in einem ersten Ausführungsbeispiel für den Fall, daß

- gemäß Anspruch 2 die Veränderung des Netzstromes zur Kurzschlußerkennung genutzt wird,

- gemäß Anspruch 7 die erste Ableitung des Netzstromes durch die Differenz zwischen einem aktuellen und einem um eine Zeit $t_V$ älteren Wert ersetzt wird,

- gemäß Anspruch 8 auf eine Fehlauslösung hin überprüft wird und diese Fehlauslösung erkannt wird,

dargestellt.

Die Zeitachse ist in äquidistante Abschnitte der Länge $\Delta t$ (29) eingeteilt. Nach Fig. 10, 11 und 12 erfaßt ein Mikroprozessor oder Controller (9) am Ende eines jeden Abschnittes der Länge $\Delta t$ (29) über einen Strom-Spannungs-Wandler (14) und einen Analog-Digital-Wandler (1) den Netzstrom $i_{NETZ}(t)$ (20) und legt den digitalisierten Meßwert in einem Ringspeicher (10) ab. Somit stehen in diesem Ringspeicher alle Stromwerte eines Zeitabschnittes.

In einem direkt anschließenden zweiten Schritt wird aus dem Ringspeicher der Netzstromwert $i_{NETZ}(t - t_v)$ einer um eine festgelegte Zeit $t_v$ zurückliegenden Messung ausgelesen und vom Wert $i_{NETZ}(t)$ substrahiert. Wenn die errechnete Differenz $\Delta i_{NETZ}$ (27) einen zulässigen Schwellwert überschreitet, wird ein Signal (3) ausgelöst, welches die Netzbremse abschaltet und dadurch die Energiezufuhr zum Filterkondensator und zum Netz unterbindet. Gleichzeitig unterbricht der Prozessor die Erfassung des Netzstromes und erfaßt nach einem Zeitintervall $t_{WK}$ (26) über einen weiteren Analog-Digital-Umsetzer (2) die Filterkondensatorspannung $u_F$ (23). Die Zeit $t_{WK}$ ist so groß gewählt, daß sich der Filterkondensator innerhalb dieser Zeit entladen kann und danach die Schutzeinrichtungen des Unterwerkes ansprechen können. Der Schwellwert für die sichere Erkennung eines Kurzschlusses wurde mit

$$i = \frac{1}{3} \, i_{NENN}$$

fixiert. Bei Verwendung der analogen Bezugsgrößen beträgt der Schwellwert im vorliegenden Beispiel

$$u = \frac{u_F}{10}$$

oder

$$P = \frac{i_{NENN} * u_F}{30}$$

bzw.

$$q = \frac{3 * i_{NENN}}{u_F}$$

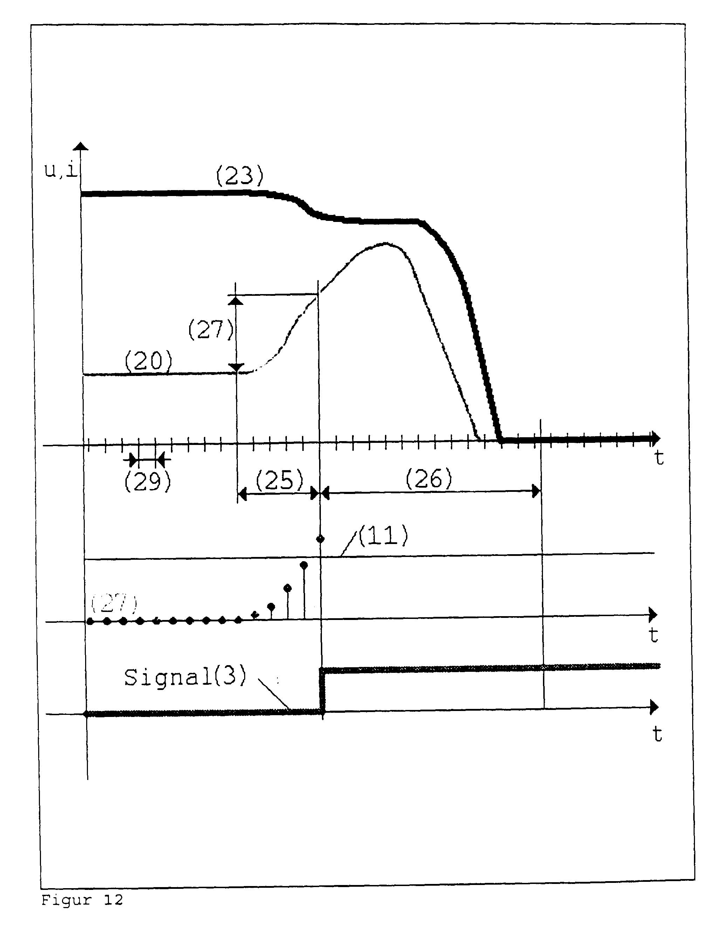

Wenn nach Ablauf der Zeit $t_{WK}$ (26) die Filterkondensatorspannung (23) noch oberhalb eines zulässigen Wertes liegt, so wurde fehlerhaft ein vermeintlicher Kurzschluß registriert und das Signal (3) wird rückgesetzt (Figur 11). Anderenfalls bleibt das Signal (3) gesetzt und damit die Netzbremse blockiert (Figur 12).

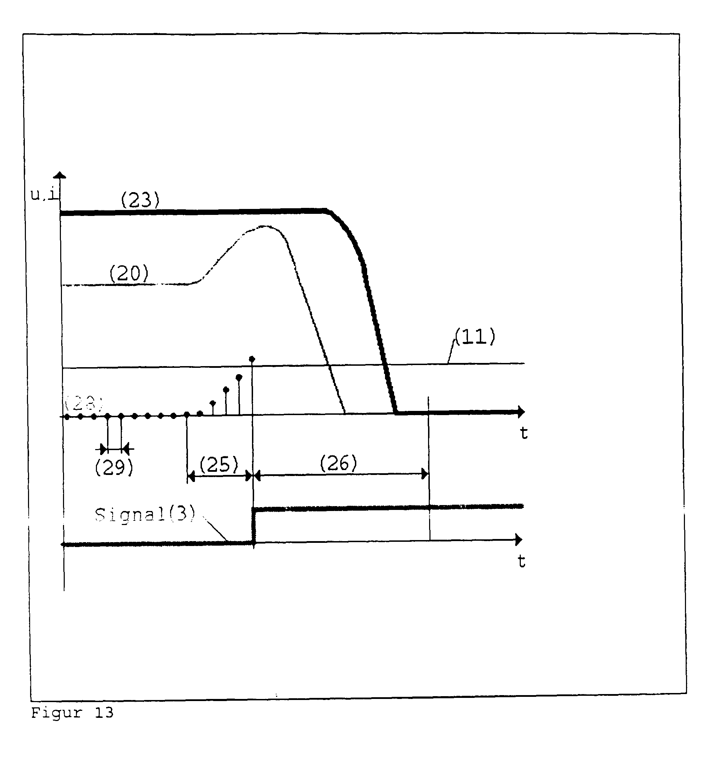

Figur 13 zeigt die zeitlichen Abläufe in einem zweiten Ausführungsbeispiel. Der wesentliche Unterschied zum ersten Ausführungsbeispiel besteht darin, daß die Veränderung des Quotienten aus Netzstrom und Filterkondensatorspannung zur Erkennung eines Kurzschlusses genutzt wird.

Die prinzipielle Vorgehensweise entspricht dem ersten Ausführungsbeispiel. Der Mikroprozessor oder Controller (9) muß zu jedem Zeitschritt $\Delta t$ (29) den digitalisierten Wert des Stromes $i_{NETZ}$ und der Spannung $u_F$ einlesen und daraus den Quotienten q (28) bilden. Dieser Quotient wird in den Ringspeicher (10) geschrieben und dann wie im ersten Ausführungsbeispiel die Differenz $\Delta q$ zum im Zeitpunkt $t - t_v$ bestimmten Quotienten $q(t - t_v)$ errechnet.

Danach ermittelt der Mikroprozessor oder Controller (9), ob die Differenz $\Delta q$ (28) einen zulässigen Schwellwert (11) überschritten hat. Ist dies der Fall, wird das Signal (3) an die Fahrzeugsteuerung gegeben und die Netzbremse abgeschaltet. Die nachfolgenden Arbeitsschritte der Schaltungsanordnung entsprechen denen des Ausführungsbeispiels 1.

**Übersicht verwendeter Bezugszeichen**

1　　Erster Analog-Digital-Wandler
2　　Zweiter Analog-Digital-Wandler
3　　Signal (zum Blockieren der Netzbremse)
4　　Fahrzeug
5　　Gleis
6　　Kurzschlußeintritt
7　　Kurzschlußstelle
8　　Leerlaufspannung (eines Unterwerkes)
9　　Mikroprozessor oder Controller
10　Ringspeicher
11　Schwellwert
12　Spannungswandler
13　Stromabnehmer
14　Strom-Spannungs-Wandler
15　Unterwerk
16　Voltmeter
17　Filterkondensator $C_F$
18　Fahrzeugsteller (wirkt als Stromquelle i)
19　Strom an der Kurzschlußstelle
20　Netzstrom des Fahrzeuges $i_{NETZ}$
21　Unterwerksabgangsstrom $i_{UW}$

22 Induktivität $L_{NETZ}$
23 Spannung am Filterkondensator $u_F$
24 Spannung am Stromabnehmer $u_S$
25 Zeitintervall $t_V$
26 Zeitintervall $t_{WK}$
27 Differenzenquotient $\Delta i_{NETZ}/t_V$
28 Differenzenquotient $\Delta q/t_V$
29 Abtastintervall $\Delta t$
30 Differenzenquotient $\Delta u/t_V$
31 Differenzenquotient $\Delta p/t_V$

**Patentansprüche**

1. Verfahren zur Kurzschlußerkennung in Bahnnetzen beim Einsatz der Netzbremse von Triebfahrzeugen, wobei die absolute Größe der Spannung am Stromabnehmer oder am Filterkondensator des Triebfahrzeuges nicht für die Erkennung des Kurzschlusses genutzt wird,
dadurch gekennzeichnet,
daß die zeitliche Änderung der Energieaufnahmefähigkeit des Netzes am oder im Triebfahrzeug ermittelt und bewertet und daß bei Überschreiten eines vorgegebenen zulässigen Schwellwertes (11) für die zeitliche Änderung der Energieaufnahmefähigkeit des Netzes die Netzbremse des Triebfahrzeuges (4) abgeschaltet wird.

2. Verfahren nach Anspruch 1,
dadurch gekennzeichnet,
daß die zeitliche Änderung der Energieaufnahmefähigkeit des Netzes durch Bestimmung der ersten Ableitung des vom Triebfahrzeug (4) in das Netz rückgespeisten Stromes $i_{NETZ}$ (20) nach der Zeit oder durch Bestimmung des in das Netz rückgespeisten Stromes $i_{NETZ}$(20) an zwei, um ein Zeitintervall $t_V$ auseinanderliegenden Zeitpunkten, und Bildung des Differenzenquotienten $\Delta i_{NETZ}/t_V$ (27) ermittelt wird.

3. Verfahren nach Anspruch 1,
dadurch gekennzeichnet,
daß die zeitliche Änderung der Energieaufnahmefähigkeit des Netzes durch Bestimmung der ersten Ableitung der am Stromabnehmer oder am Filterkondensator des Triebfahrzeuges (4) anliegenden Spannung $u_S$ (24) bzw. $u_F$ (23) nach der Zeit oder durch Bestimmung der Spannung $u_S$ (24) bzw. $u_F$ (23) an zwei, um ein Zeitintervall $t_V$ auseinderliegenden, Zeitpunkten und Bildung des Differenzenquotienten $\Delta u_S/t_V$ bzw. $\Delta u_F/t_V$ (30) ermittelt wird.

4. Verfahren nach Anspruch 1,
dadurch gekennzeichnet,
daß die zeitliche Änderung der Energieaufnahmefähigkeit des Netzes durch Bestimmung der ersten Ableitung des Produktes p aus dem in das Netz rückgespeisten Strom $i_{NETZ}$ (20) des Triebfahrzeuges (4) und der Spannung $u_S$ am Stromabnehmer (24) oder der Spannung $u_F$ am Filterkondensator (23) des Triebfahrzeuges (4) nach der Zeit oder durch Bestimmung dieses Produktes p an zwei, um ein Zeitintervall $t_V$ auseinderliegenden, Zeitpunkten und Bildung des Differenzenquotienten $\Delta p/t_V$ (31) ermittelt wird.

5. Verfahren nach Anspruch 1,
dadurch gekennzeichnet,
daß die zeitliche Änderung der Energieaufnahmefähigkeit des Netzes durch Bestimmung der ersten Ableitung des Quotienten q aus dem in das Netz rückgespeisten Strom $i_{NETZ}$ (20) des Triebfahrzeuges (4) und der Spannung $u_S$ am Stromabnehmer (24) oder der Spannung $u_F$ am Filterkondensator (23) des Triebfahrzeuges (4) nach der Zeit oder durch Bestimmung dieses Quotienten q an zwei, um ein Zeitintervall $t_V$ auseinanderliegenden, Zeitpunkten und Bildung des Differenzenquotienten $\Delta q/t_V$ (28) ermittelt wird.

6. Verfahren nach einem der Ansprüche 2 bis 5,
dadurch gekennzeichnet,
daß die zeitliche Änderung der Energieaufnahmefähigkeit des Netzes durch mathematische Verknüpfung der am oder im Triebfahrzeug (4) anliegenden Meßgrößen $i_{NETZ}$ (20) und $u_F$ (23) oder $u_S$ (24) und die fortlaufende Bestimmung der ersten Ableitung dieser Rechengrößen nach der Zeit oder durch die Bildung der Differenzenquotienten ermittelt wird.

7. Verfahren nach einem der Ansprüche 1 bis 6,
dadurch gekennzeichnet,
daß zur Ermittlung der ersten Ableitung die auszuwertenden Meßgrößen intervallartig bestimmt und gespeichert werden, von dem zum Zeitpunkt t erfaßten Wert der zum Zeitpunkt $t-t_V$ erfaßte Wert subtrahiert und das Ergebnis mit einem festgelegten Schwellwert (11) verglichen wird.

8. Verfahren nach einem der Ansprüche 1 bis 7,
dadurch gekennzeichnet,
daß die abgeschaltete Netzbremse nach einem Zeitintervall $t_{WK}$ (26) wieder wirksam wird, wenn die Spannung $u_S$ (24) am Stromabnehmer (13) des Triebfahrzeuges (4) oder die Spannung $u_F$ am Filterkondensator (23) innerhalb eines zulässigen Bereiches liegt, wobei $t_{WK}$ (26) der Zeitdauer entspricht, die für die vollständige Entladung der Filterkapazitäten im Triebfahrzeug (4) sowie für die sichere Auslösung der Unterwerksschutzeinrichtung benötigt wird.

9. Schaltungsanordnung zur Durchführung des Verfahrens nach einem der Ansprüche 1, 2, 7 oder 8,

dadurch gekennzeichnet,

daß ein Mikroprozessor oder Controller (9) über einen Analog-Digital-Wandler (1) mit einem Strom-Spannungs-Wandler (14), mit einem weiteren Analog-Digital-Wandler (2) zur Spannungserfassung und einem Ringspeicher (10) verbunden ist,

daß der Mikroprozessor oder Controller (9) in Intervallen $\Delta t$ (29) den Netzstrom $i_{NETZ}(t)$ (20) erfaßt und den digitalisierten Meßwert im Ringspeicher (10) ablegt,

daß nach der Meßwerterfassung vom Mikroprozessor oder Controller (9) aus dem Ringspeicher (10) der Netzstromwert $i_{NETZ}(t-t_v)$ einer um ein Zeitintervall $t_v$ (25) zurückliegenden Messung ausgelesen und vom Wert $i_{NETZ}(t)$ subtrahiert wird,

daß der Mikroprozessor oder Controller (9) die errechnete Differenz $\Delta i_{NETZ}$ (27) mit einem zulässigen Schwellwert (11) vergleicht,

daß bei Überschreiten des Schwellwertes (11) ein Signal (3) ausgelöst wird, welches die Netzbremse abschaltet und die Energiezufuhr zum Filterkondensator und zum Netz unterbricht,

daß der Mikroprozessor oder Controller (9) die Erfassung des Netzstromes $i_{NETZ}$ (20) unterbricht und nach einem Zeitintervall $t_{WK}$ (26) über den weiteren Analog-Digital-Wandler (2) die Filterkondensatorspannung $u_F$ (23) oder die Spannung am Stromabnehmer $u_S$ (24) ermittelt, wobei das Zeitintervall $t_{WK}$ (26) so groß ist, daß sich der Filterkondensator (17) des Triebfahrzeuges innerhalb dieser Zeit entlädt und die Schutzeinrichtungen des benachbarten Unterwerkes (15) sicher ansprechen,

daß der Mikroprozessor oder Controller (9) nach Ablauf des Zeitintervalles $t_{WK}$ (26) die Filterkondensatorspannung $u_F$ (23) mit einem zulässigen Wert vergleicht und in Abhängigkeit vom Ergebnis die Netzbremse freigibt oder weiter blockiert.

10. Schaltungsanordnung zur Durchführung des Verfahrens nach einem der Ansprüche 1, 3, 7 oder 8, dadurch gekennzeichnet,

daß ein Mikroprozessor oder Controller (9) über einen Analog-Digital-Wandler (1) mit einem Strom-Spannungs-Wandler (14), mit einem weiteren Analog-Digital-Wandler (2) zur Spannungserfassung und einem Ringspeicher (10) verbunden ist,

daß der Mikroprozessor oder Controller (9) in Intervallen $\Delta t$ (29) die Filterkondensatorspannung $u_F(t)$ (23) erfaßt und den digitalisierten Meßwert im Ringspeicher (10) ablegt,

daß nach der Meßwerterfassung vom Mikroprozessor oder Controller (9) aus dem Ringspeicher (10) die Filterkondensatorspannung $u_F(t-t_v)$ einer um ein Zeitintervall $t_v$ (25) zurückliegenden Messung ausgelesen und vom Wert $u_F(t)$ (23) subtrahiert wird,

daß der Mikroprozessor oder Controller (9) die errechnete Differenz $\Delta u_F$ mit einem zulässigen Schwellwert (11) vergleicht,

daß bei Überschreiten des Schwellwertes (11) ein Signal (3) ausgelöst wird, welches die Netzbremse abschaltet und die Energiezufuhr zum Filterkondensator (17) und zum Netz unterbricht,

daß der Mikroprozessor oder Controller (9) nach einem Zeitintervall $t_{WK}$ (26) die Filterkondensatorspannung $u_F$ (23) ermittelt, wobei das Zeitintervall $t_{WK}$ (26) so groß ist, daß sich der Filterkondensator (17) des Triebfahrzeuges (4) innerhalb dieser Zeit entlädt und die Schutzeinrichtungen des benachbarten Unterwerkes (15) sicher ansprechen,

daß der Mikroprozessor oder Controller (9) nach Ablauf des Zeitintervalles $t_{WK}$ (26) die Filterkondensatorspannung $u_F$ (23) mit einem zulässigen Wert vergleicht und in Abhängigkeit vom Ergebnis die Netzbremse freigibt oder weiter blockiert.

11. Schaltungsanordnung zur Durchführung des Verfahrens nach einem der Ansprüche 1, 3, 7 oder 8, dadurch gekennzeichnet,

daß ein Mikroprozessor oder Controller (9) über einen Analog-Digital-Wandler (1) mit einem Strom-Spannungs-Wandler (14), mit einem weiteren Analog-Digital-Wandler (2) zur Spannungserfassung und einem Ringspeicher (10) verbunden ist,

daß der Mikroprozessor oder Controller (9) in Intervallen $\Delta t$ (29) die Spannung am Stromabnehmer $u_S(t)$ (24) erfaßt und den digitalisierten Meßwert im Ringspeicher (10) ablegt,

daß nach der Meßwerterfassung vom Mikroprozessor oder Controller (9) aus dem Ringspeicher die Spannung $u_S(t-t_v)$ einer um ein Zeitintervall $t_v$ (25) zurückliegenden Messung ausgelesen und vom Wert $u_S(t)$ (24) subtrahiert wird,

daß der Mikroprozessor oder Controller (9) die errechnete Differenz $\Delta u_S$ mit einem zulässigen Schwellwert (11) vergleicht,

daß bei Überschreiten des Schwellwertes (11) ein Signal (3) ausgelöst wird, welches die Netzbremse abschaltet und die Energiezufuhr zum Filterkondensator (17) und zum Netz unterbricht,

daß der Mikroprozessor oder Controller (9) nach einem Zeitintervall $t_{WK}$ (26) die Spannung am Stromabnehmer $u_S$ (24) ermittelt, wobei das Zeitintervall $t_{WK}$ (26) so groß ist, daß sich der Filterkondensator (17) des Triebfahrzeuges (4) innerhalb dieser Zeit entlädt und die Schutzeinrichtungen des benachbarten Unterwerkes (15) sicher ansprechen,

daß der Mikroprozessor oder Controller (9) nach Ablauf des Zeitintervalles $t_{WK}$ (26) die Spannung am Stromabnehmer $u_S$ (24) mit einem zulässigen Wert vergleicht und in Abhängigkeit vom Ergebnis die Netzbremse freigibt oder weiter blockiert.

**Claims**

1. Procedure for identifying short circuits in traction systems when applying the system brake of traction vehicles, whereby the absolute value of the voltage at the collector or at the filter capacitor of the traction vehicle is not used for identifying the short circuit, characterised by the fact that the time rate of change of the system's power consumption capacity is established and assessed at or in the traction vehicle and the system brake of the traction vehicle (4) is disconnected when a predetermined permissible threshold value (11) for the time rate of change of the system's power consumption capacity is exceeded.

2. Procedure as claimed in Claim 1, characterised by the fact that the time rate of change of the system's power consumption capacity is established by determining the first derivative with respect to time of the current iNETZ (20) fed back into the system by the traction vehicle (4) or by determining the current iNETZ (20) fed back into the system at two points in time separated by a time interval tv and by producing the difference quotient D iNETZ/tv (27).

3. Procedure as claimed in Claim 1, characterised by the fact that the time rate of change of the system's power consumption capacity is established by determining the first derivative with respect to time of the adjacent voltage uS (24) or uF (23) at the collector or filter capacitor of the traction vehicle (4) or by determining the voltage uS (24) or uF (23) at two points in time separated by a time interval tv and by producing the difference quotient D uS/tv or D uF/tv (30).

4. Procedure as claimed in Claim 1, characterised by the fact that the time rate of change of the system's power consumption capacity is established by determining the first derivative with respect to time of the product p of the current iNETZ (20) fed back into the system by the traction vehicle (4) and of the voltage uS at the collector (24) or of the voltage uF at the filter capacitor (23) of the traction vehicle (4) or by determining this product p at two points in time separated by a time interval tv and by producing the difference quotient D p/tv (31).

5. Procedure as claimed in Claim 1, characterised by the fact that the time rate of change of the system's power consumption capacity is established by determining the first derivative with respect to time of the quotient q of the current iNETZ (20) fed back into the system by the traction vehicle (4) and of the voltage uS at the collector (24) or of the voltage uF at the filter capacitor (23) of the traction vehicle (4) or by determining this quotient q at two points in time separated by a time interval tv and by producing the difference quotient D q/tv (28).

6. Procedure as claimed in one of the Claims 2 to 5, characterised by the fact that the time rate of change of the system's power consumption capacity is established by linking the adjacent quantities iNETZ (20) and uF (23) or uS (24) being measured at or in the traction vehicle (4) mathematically and by continuing to determine the first derivative with respect to time of these operands or by producing difference quotients.

7. Procedure as claimed in one of the Claims 1 to 6, characterised by the fact that to establish the first derivative, the quantities to be evaluated are determined at intervals and stored, the value recorded at t - tv is subtracted from the value recorded at t and the result compared with a set threshold value (11).

8. Procedure as claimed in one of the Claims 1 to 7, characterised by the fact that after a time interval tWK (26), the disconnected system brake becomes operative again if the voltage uS (24) at the collector (13) of the traction vehicle (4) or the voltage uF at the filter capacitor (23) lies within a permissible range, whereby tWK (26) represents the period of time required for the filter capacitors in the traction vehicle (4) to discharge completely and also for the transformer substation's safety device to be released reliably.

9. Circuit arrangement to carry out the procedure as claimed in one of the Claims 1, 2, 7 or 8, characterised by the fact that

a microprocessor or controller (9) is connected via an analogue to digital converter (1) to a current voltage converter (14), to an additional analogue to digital converter (2) for recording voltages and to a ring store (10),

the microprocessor or controller (9) records the mains current iNETZ (t) (20) at intervals D t (29) and deposits the digitized measured value in the ring store (10),

once the measured value has been recorded by the microprocessor or controller (9), the mains current value iNETZ (t-tv) of an earlier measurement preceding by a time interval tv (25) is read out from the ring store (10) and subtracted from the value INETZ (t),

the microprocessor or controller (9) compares the difference D iNETZ (27) thus calculated with a permissible threshold value (11),

if the threshold value (11) is exceeded, a signal (3) is triggered which disconnects the system brake and interrupts the power supply to the filter capacitor and the system,

the microprocessor or controller (9) stops recording the mains current iNETZ (20) and, after a time interval tWK (26), establishes the filter capacitor voltage uF (23) or the voltage at the current collector uS (24) via the additional analogue to digital converter (2), whereby the time interval tWK (26) is long enough for the filter capacitor (17) of the traction vehicle to be discharged within this time and the safety devices of the adjacent transformer substation (15) to respond reliably,

after the time interval tWK (26), the microprocessor or controller (9) compares the filter capacitor voltage uF (23) with a permissible value and, depending upon the result, releases or continues to lock the system brake.

10. Circuit arrangement to carry out the procedure as claimed in one of the Claims 1, 3, 7 or 8, characterised by the fact that

a microprocessor or controller (9) is connected via an analogue to digital converter (1) to a current voltage converter (14), to an additional analogue to digital converter (2) for recording voltages and to a ring store (10),

the microprocessor or controller (9) records the filter capacitor voltage uF(t) (23) at intervals D t (29) and deposits the digitized measured value in the ring store (10),

once the measured value has been recorded by the microprocessor or controller (9), the filter capacitor voltage uF(t-tv) of an earlier measurement preceding by a time interval tv (25) is read out from the ring store (10) and subtracted from the value uF(t) (23),

the microprocessor or controller (9) compares the difference D uF thus calculated with a permissible threshold value (11),

if the threshold value (11) is exceeded, a signal (3) is triggered which disconnects the system brake and interrupts the power supply to the filter capacitor (17) and the system,

after a time interval tWK (26), the microprocessor or controller (9) establishes the filter capacitor voltage uF (23), whereby the time interval tWK (26) is long enough for the filter capacitor (17) of the traction vehicle (4) to be discharged within this time and the safety devices of the adjacent transformer substation (15) to respond reliably,

after the time interval tWK (26), the microprocessor or controller (9) compares the filter capacitor voltage uF (23) with a permissible value and, depending upon the result, releases or continues to lock the system brake.

11. Circuit arrangement to carry out the procedure as claimed in one of the Claims 1, 3, 7 or 8, characterised by the fact that

a microprocessor or controller (9) is connected via an analogue to digital converter (1) to a current voltage converter (14), to an additional analogue to digital converter (2) for recording voltages and to a ring store (10),

the microprocessor or controller (9) records the voltage at the current collector uS (t) (24) at intervals D t (29) and deposits the digitized measured value in the ring store (10),

once the measured value has been recorded by the microprocessor or controller (9), the voltage uS (t-tv) of an earlier measurement preceding by a time interval tv (25) is read out from the ring store (10) and subtracted from the value uS (t) (24),

the microprocessor or controller (9) compares the difference D uS thus calculated with a permissible threshold value (11),

if the threshold value (11) is exceeded, a signal (3) is triggered which disconnects the system brake and interrupts the power supply to the filter capacitor (17) and the system,

after a time interval tWK (26), the microprocessor or controller (9) establishes the voltage at the current collector uS (24), whereby the time interval tWK (26) is long enough for the filter capacitor (17) of the traction vehicle (4) to be discharged within this time and the safety devices of the adjacent transformer substation (15) to respond reliably,

after the time interval tWK (26), the microprocessor or controller (9) compares the voltage at the current collector uS (24) with a permissible value and, depending upon the result, releases or continues to lock the system brake.

**Revendications**

1.  Procédé pour détecter des courts-circuits dans des réseaux ferroviaires lors de l'utilisation du frein de réseau de véhicules moteurs, la valeur absolue de la tension électrique sur le pantographe ou sur le condensateur de filtration du véhicule moteur n'étant pas utilisée pour la détection du court-circuit, **caractérisé** en ce qu'on détermine et on évalue la modification dans le temps de la capacité d'absorption d'énergie du réseau sur ou dans le véhicule moteur, et en ce qu'on déconnecte le frein de réseau du véhicule moteur (4) en cas de dépassement d'une valeur de seuil admissible prédéfinie (11) pour la modification dans le temps de la capacité d'absorption d'énergie du réseau.

2.  Procédé selon la revendication 1, **caractérisé** en ce qu'on détermine la modification dans le temps de la capacité d'absorption d'énergie du réseau en déterminant la dérivée première en fonction du temps de l'intensité électrique $i_{NETZ}$ (20) renvoyée dans le réseau par le véhicule moteur (4), ou en déterminant l'intensité $i_{NETZ}$ (20) renvoyée dans le réseau en deux instants mutuellement distants d'un intervalle de temps $t_v$, et en formant le quotient différentiel $\Delta i_{NETZ}/t_v$ (27).

3.  Procédé selon la revendication 1, **caractérisé** en ce qu'on détermine la modification dans le temps de la capacité d'absorption d'énergie du réseau en déterminant la dérivée première en fonction du temps de la tension électrique $U_S$ (24) ou $U_F$ (23) présente sur le pantographe ou sur le condensateur de filtration du véhicule moteur (4), ou en déterminant la tension us (24) ou $u_F$ (23) en deux instants mutuellement distants d'un intervalle de temps $t_v$, et en formant le quotient différentiel $\Delta u_S/t_v$ ou $\Delta u_F/t_v$ (30).

4.  Procédé selon la revendication 1, **caractérisé** en ce qu'on détermine la modification dans le temps de la capacité d'absorption d'énergie du réseau en déterminant la dérivée première en fonction du temps du produit p de l'intensité $i_{NETZ}$ (20) renvoyée dans le réseau par le véhicule moteur (4) et de la tension $u_S$ sur le pantographe (24) ou de la tension $u_F$ sur le condensateur de filtration (23) du véhicule moteur (4), ou en déterminant ce produit p en deux instants mutuellement distants d'un intervalle de temps $t_v$, et en formant le quotient différentiel $\Delta p/t_v$ (31).

5.  Procédé selon la revendication 1, **caractérisé** en ce qu'on détermine la modification dans le temps de la capacité d'absorption d'énergie du réseau en déterminant la dérivée première en fonction du temps du quotient q de l'intensité $i_{NETZ}$ (20) renvoyée dans le réseau par le véhicule moteur (4) et de la tension $u_S$ sur le pantographe (24) ou de la tension $u_F$ sur le condensateur de filtration (23) du véhicule moteur (4), ou en déterminant ce quotient q en deux instants mutuellement distants d'un intervalle de temps $t_v$, et en formant le quotient différentiel $\Delta q/t_v$ (28).

6.  Procédé selon une des revendications 2 à 5, **caractérisé** en ce qu'on détermine la modification dans le temps de la capacité d'absorption d'énergie du réseau par la liaison mathématique des variables mesurées $i_{NETZ}$ (20) et $u_S$ (24) ou $u_F$ (23) présentes sur ou dans le véhicule moteur (4), et par la détermination en continu de la dérivée première en fonction du temps de ces opérandes, ou par la formation des quotients différentiels.

7.  Procédé selon une des revendications 1 à 6, **caractérisé** en ce que, pour déterminer la dérivée première, les variables mesurées à interpréter sont déterminées et mémorisées à intervalles, la valeur enregistrée à l'instant t-t$_v$ est soustraite de la valeur enregistrée à l'instant t, et le résultat est comparé à une valeur de seuil (11) fixée.

8. Procédé selon une des revendications 1 à 7, **caractérisé** en ce que le frein de réseau déconnecté redevient actif au bout d'un intervalle de temps t$_{WK}$ (26) si la tension us (24) sur le pantographe (13) du véhicule moteur (4) ou la tension u$_F$ sur le condensateur de filtration (23) se situe à l'intérieur d'une plage admissible, t$_{WK}$ (26) correspondant à la durée qui est nécessaire pour le déchargement total des capacités de filtration dans le véhicule moteur (4) ainsi que pour le déclenchement fiable du dispositif de protection de la sous-station.

9. Montage pour la mise en oeuvre du procédé selon une des revendications 1, 2, 7 ou 8, **caractérisé** en ce qu'un microprocesseur ou contrôleur (9) est relié par l'intermédiaire d'un convertisseur analogique-numérique (1) à un convertisseur intensité-tension (14), à un convertisseur analogique-numérique supplémentaire (2) pour l'enregistrement de la tension électrique, et à une mémoire annulaire (10),

en ce que le microprocesseur ou contrôleur (9) enregistre à intervalles $\Delta$t (29) l'intensité de réseau i$_{NETZ}$(t) (20) et dépose la valeur de mesure numérisée dans la mémoire annulaire (10),
en ce qu'à la suite de l'enregistrement de la valeur de mesure, le microprocesseur ou contrôleur (9) extrait de la mémoire annulaire (10) la valeur d'intensité de réseau i$_{NETZ}$(t-t$_v$) d'une mesure précédente d'un intervalle de temps t$_v$ (25), et la soustrait de la valeur i$_{NETZ}$(t),
en ce que le microprocesseur ou contrôleur (9) compare la différence calculée $\Delta$i$_{NETZ}$ (27) à une valeur de seuil admissible (11),
en ce qu'en cas de dépassement de la valeur de seuil (11), un signal (3) est déclenché, qui déconnecte le frein de réseau et interrompt l'alimentation en énergie du condensateur de filtration et du réseau,
en ce que le microprocesseur ou contrôleur (9) interrompt l'enregistrement de l'intensité de réseau i$_{NETZ}$ (20) et, au bout d'un intervalle de temps t$_{WK}$ (26), détermine par l'intermédiaire du convertisseur analogique-numérique supplémentaire (2) la tension du condensateur de filtration u$_F$ (23) ou la tension sur le pantographe u$_S$ (24), l'intervalle de temps t$_{WK}$ (26) étant suffisamment grand pour que le condensateur de filtration (17) du véhicule moteur se décharge à l'intérieur de cette durée et que les dispositifs de protection de la sous-station voisine (15) réagissent de manière fiable,
en ce que le microprocesseur ou contrôleur (9), à l'expiration de l'intervalle de temps t$_{WK}$ (26), compare la tension du condensateur de filtration u$_F$ (23) à une valeur admissible et, en fonction du résultat, libère ou continue à bloquer le frein de réseau.

10. Montage pour la mise en oeuvre du procédé selon une des revendications 1, 3, 7 ou 8, **caractérisé** en ce qu'un microprocesseur ou contrôleur (9) est relié par l'intermédiaire d'un convertisseur analogique-numérique (1) à un convertisseur intensité-tension (14), à un convertisseur analogique-numérique supplémentaire (2) pour l'enregistrement de la tension électrique, et à une mémoire annulaire (10),

en ce que le microprocesseur ou contrôleur (9) enregistre à intervalles $\Delta$t (29) la tension du condensateur de filtration u$_F$(t) (23) et dépose la valeur de mesure numérisée dans la mémoire annulaire (10),
en ce qu'à la suite de l'enregistrement de la valeur de mesure, le microprocesseur ou contrôleur (9) extrait de la mémoire annulaire (10) la tension du condensateur de filtration u$_F$(t-t$_v$) d'une mesure précédente d'un intervalle de temps t$_v$ (25), et la soustrait de la valeur u$_F$(t) (23),
en ce que le microprocesseur ou contrôleur (9) compare la différence calculée $\Delta$u$_F$ à une valeur de seuil admissible (11),
en ce qu'en cas de dépassement de la valeur de seuil (11), un signal (3) est déclenché, qui déconnecte le frein de réseau et interrompt l'alimentation en énergie du condensateur de filtration (17) et du réseau,
en ce que le microprocesseur ou contrôleur (9), au bout d'un intervalle de temps t$_{WK}$ (26), détermine la tension du condensateur de filtration u$_F$ (23), l'intervalle de temps t$_{WK}$ (26) étant suffisamment grand pour que le condensateur de filtration (17) du véhicule moteur (4) se décharge à l'intérieur de cette durée et que les dispositifs de protection de la sous-station voisine (15) réagissent de manière fiable,
en ce que le microprocesseur ou contrôleur (9), à l'expiration de l'intervalle de temps t$_{WK}$ (26), compare la tension du condensateur de filtration u$_F$ (23) à une valeur admissible et, en fonction du résultat, libère ou continue à bloquer le frein de réseau.

11. Montage pour la mise en oeuvre du procédé selon une des revendications 1, 3, 7 ou 8, **caractérisé** en ce qu'un microprocesseur ou contrôleur (9) est relié par l'intermédiaire d'un convertisseur analogique-numérique (1) à un convertisseur intensité-tension (14), à un convertisseur analogique-numérique supplémentaire (2) pour l'enregistrement de la tension électrique, et à une mémoire annulaire (10),

en ce que le microprocesseur ou contrôleur (9) enregistre à intervalles Δt (29) la tension sur le pantographe $u_S(t)$ (24) et dépose la valeur de mesure numérisée dans la mémoire annulaire (10),

en ce qu'à la suite de l'enregistrement de la valeur de mesure, le microprocesseur ou contrôleur (9) extrait de la mémoire annulaire la tension $u_S(t-t_v)$ d'une mesure précédente d'un intervalle de temps $t_v$ (25), et la soustrait de la valeur $u_S(t)$ (24),

en ce que le microprocesseur ou contrôleur (9) compare la différence calculée $\Delta u_S$ à une valeur de seuil admissible (11),

en ce qu'en cas de dépassement de la valeur de seuil (11), un signal (3) est déclenché, qui déconnecte le frein de réseau et interrompt l'alimentation en énergie du condensateur de filtration (17) et du réseau,

en ce que le microprocesseur ou contrôleur (9), au bout d'un intervalle de temps $t_{WK}$ (26), détermine la tension sur le pantographe $u_S$ (24), l'intervalle de temps $t_{WK}$ (26) étant suffisamment grand pour que le condensateur de filtration (17) du véhicule moteur (4) se décharge à l'intérieur de cette durée et que les dispositifs de protection de la sous-station voisine (15) réagissent de manière fiable,

en ce que le microprocesseur ou contrôleur (9), à l'expiration de l'intervalle de temps $t_{WK}$ (26), compare la tension sur le pantographe $u_S$ (24) à une valeur admissible et, en fonction du résultat, libère ou continue à bloquer le frein de réseau.

Figur 1

Figur 2

Figur 3

Figur 4

Figur 5

Figur 6

Figur 7

Figur 8

Figur 9

Figur 10

Figur 11

Figur 12

Figur 13